# EUROPÄISCHE PATENTSCHRIFT

(11) **EP 0 462 050 B1**
(45) Veröffentlichungstag und Bekanntmachung des Hinweises auf die Patenterteilung: **25.05.1994**
(21) Anmeldenummer: 91810372.2
(22) Anmeldetag: 15.05.1991
(51) Int. Cl.: H02P 8/00, G01R 31/34

(54) **Verfahren und Schaltung zum Erfassen des Aussertrittfallens eines Schritt- oder Synchronmotors**
Method and circuit for detecting the drop from synchronism of a stepper or synchronous motor
Procédé et circuit de détection de la perte de synchronisme d'un moteur pas à pas ou synchrone

(30) Priorität: 12.06.1990 CH 1980/90
(43) Veröffentlichungstag der Anmeldung: 18.12.1991
(73) Patentinhaber: SAIA AG, CH-3280 Murten (CH)
(72) Erfinder: Boillat, Pierre, CH-3280 Meyriez (CH)
(74) Vertreter: Steiner, Martin

(56) Entgegenhaltungen:
- DE-A- 3 809 436
- DE-B- 2 312 170
- GB-A- 2 122 749
- US-A- 4 791 343
- IEE PROCEEDINGS-B/ELECTRIC POWER APPLICATIONS, Band 135, Nr. 1, Januar 1988, Seiten 27-32; J.T. BOYS: "Novel current sensor for PWM AC drives"

## Beschreibung

Die vorliegende Erfindung betrifft ein Verfahren und einer Schaltung zum Erfassen des Aussertrittfallens eines Schritt- oder Synchronmotors, insbesondere eines Kleinmotors. Solche Motoren werden in zunehmendem Masse für alle möglichen Antriebsaufgaben verwendet, inbesondere zum Verstellen bestimmter Organe in Automobilen, in Büromaschinen usw. Schritt- oder Synchronmotoren können dabei bei Ueberlastung aussertrittfallen, unter anderem wenn ein zu verstellendes Organ gegen einen Anschlag anläuft. Die Erfahrung zeigt, dass hierbei die Annahme unrealistisch wäre, der Motor verliere gelegentlich einen Schritt. Vielmehr verliert der Motor praktisch immer mehrere Schritte und neigt dazu, in einen Schwingungszustand überzugehen, was Lärm verursacht und die meistens vorhandenen Untersetzungsgetriebe stark beansprucht. In gewissen Fällen kann der Motor rückwärts anlaufen und sich synchronisieren was ebenso unerwünscht ist. In den erwähnten Fällen ergibt sich auch ein nachteiliger Zeitverlust.

Es besteht daher das Bedürfnis, jedes Aussertrittfallen des Motors zu erfassen und entsprechende Massnahmen zu ergreifen, insbesondere den Motor vorübergehend oder dauernd auszuschalten.

Es sind verschiedene Lösungen zum Erfassen des Verlustes von Schritten bzw. des Aussertrittfallens eines Schritt- oder Synchronmotors bekannt.

US -A- 4 791 343 offenbart ein Verfahren zum Erfassen des Außertrittfallens eines Schrittmotors. Dazu wird ein Sensor vorgeschlagen, der den Motorstrom differenziert. Sofern der Wert des differenzierten Stroms innerhalb eines bestimmten Zeitpunktes unter einen vorgegebenen Wert fällt, wurde ein Schritt ausgeführt; sofern der differenzierte Motorstrom innerhalb des vorgegebenen Zeitintervalles nicht unter den vorgegebenen Wert sinkt, hat der Motor den Schritt nicht ausgeführt. Der Sensorausgang ist mit einer Auswerteschaltung verbunden, die somit stets die aktuelle Position des Antriebes erkennt. Ziel vorliegender Erfindung ist es, eine einfache kostengünstige Lösung anzugeben, d.h. den Aufwand den geringen Kosten der heute verfügbaren Kleinsynchron- oder Schrittmotoren anzupassen. Die erfindungsgemässe Lösung ist in den Ansprüchen 1 und 6 definiert.

In folgenden wird ein Ausführungsbeispiel einer erfindungsgemässen Schaltung, anhand der Zeichnung, näher erläutert.
- Fig. 1: zeigt die Schaltung,
- Fig. 2: zeigt einige wesentliche in der Schaltung auftretende Signale und
- Fig. 3: zeigt einen Schaltungsteil für den Fall einer bestimmten Regelung des Motors.

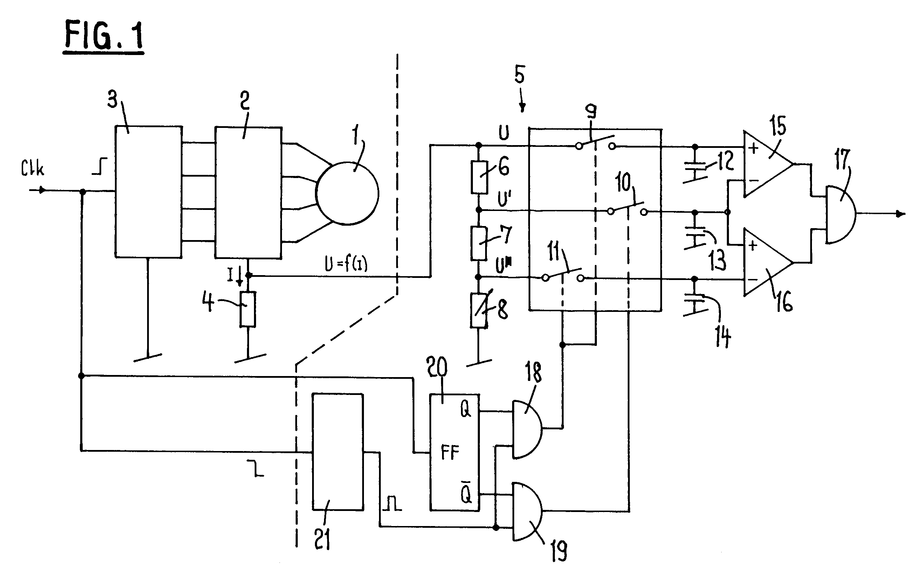

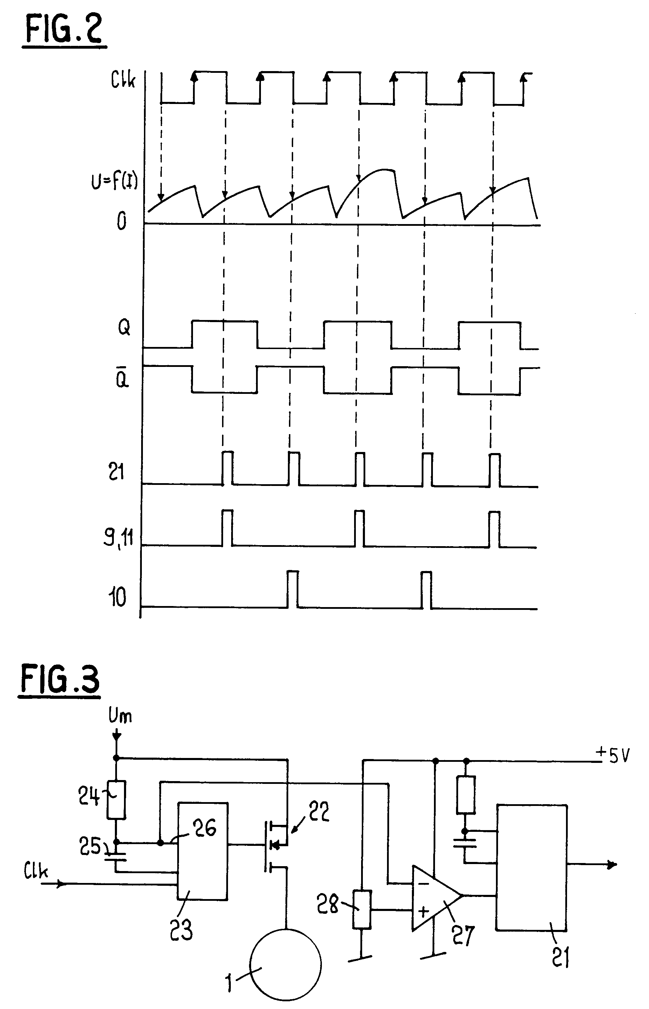

Fig. 1 zeigt den Schritt- oder Synchronmotor 1, beispielsweise einen Zwei- oder Vierphasenmotor. Seine Wicklungen werden durch einen Treiber 2 in einer durch einen Sequenzgeber 3 bestimten Folge mit Antriebsimpulsen gespeist. Die Frequenz dieser Impulse bzw. die Drehzahl des Motors wird bestimmt durch ein Taktsignal Clk, dass dem Eingang des Sequenzgebers zugeführt wird. Der gesamte über den Treiber 2 dem Motor 1 zugeführte Strom fliesst über einen Widerstand 4, und der dem Motorstrom proportionale Spannungsabfall U=f(I), wird einer Tastspeicherschaltung zugeführt. Diese Schaltung weist einen Spannungteiler bestehend aus Widerständen 6 und 7 sowie einem Potentiometer 8 auf, so dass an allen drei Eingängen abgestufte proportionale Spannungen U, U′ und U˝ auftreten. Schematisch dargestellte Tastschalter 9, 10 und 11, die aber tatsächlich als elektronische Bauteile integriert sind, gestatten die Spannungen U, U′ und U˝ Speicherkondensatoren 12, 13 und 14 zuzuführen. Durch wechselsweises kurzzeitiges Schliessen der Schalter 9, 10 und 11 wird jeweils ein momentaner Spannungszustand an die Kondensatoren 12, 13 und 14 übertragen und dort gespeichert. Die Kondensatoren 12, 13 und 14 sind mit Operationsverstärkern 15 und 16 verbunden, deren Ausgänge mit den Eingängen eines UND-Tors 17 verbunden sind. Der Ausgang dieses Tors 17 liefert die Information darüber, ob der Motor normal arbeitet oder aussertrittgefallen ist. Die Tastschalter 9 und 11, für die höchste Spannung U und die niedrigste Spannung U˝, werden angesteuert vom Ausgang eines UND-Tors 18 während der Tastschalter 10 für die mittlere Spannung U′ angesteuert wird vom Ausgang eines UND-Tors 19. Je ein Eingang der Tore 18 und 19 ist verbunden mit den Ausgängen Q bzw. Q̅ eines Flip-Flops 20, dessen Eingang mit dem Takteingang Clk verbunden ist. Der andere Eingang jedes Tores 18 und 19 ist verbunden mit dem Ausgang eines Univibrators 21, dessen Eingang ebenfalls mit dem Takteingang Clk verbunden ist. Wie in Fig. 1 angedeutet, wird der Sequenzgeber 3 durch die ansteigende Flanke der Taktimpulse gesteuert, während der Univibrator 21 durch die absteigende Flanke der Taktimpulse gesteuert ist. Fig. 2 dient der Erläuterung der Arbeitsweise der in Fig. 1 dargestellten Schaltung. Fig. 2 zeigt das Taktsignal Clk. Wie eben erwähnt, wird bei ansteigender Flanke jedes Taktimpulses die Weiterschaltung des Motors ausgelöst, d.h. die Umschaltung der Motorwicklung wird eingeleitet, wobei die Stromstärke des vorher fliessenden Antriebsimpulses steil abfällt und dann mit einer gewissen Verzögerung die Stromstärke des nächsten Antriebsimpulses ansteigt. Entsprechend diesem Stromverlauf tritt am Widerstand 4 ein entsprechender Spannungsabfall U=f(I) auf, der in Fig. 2 dargestellt ist. Es handelt sich also um einen sägezahnartigen Strom- bzw. Spannungsverlauf. Solange der Motor normal arbeitet, ist dieser Strom bzw. Spannungsverlauf für jeden Schaltschritt praktisch gleich, wobei verhältnismässig langsame Aenderungen eintreten können, wenn sich das Lastmoment des Motors, dessen Temperatur oder die Betriebsspannung ändert. Dieser Zustand ist in Fig. 2 für die drei ersten Schritte bzw. Antriebsimpulse dargestellt. Fällt nun der Motor aus irgendeinem Grunde aussertritt, dann treten völlig abweichende, unregelmässige Strom- bzw. Spannungsimpulse auf, wie in Fig. 2 für den dritten bis sechsten Impuls bzw. Schritt dargestellt.

Der Flip-Flop 20 wird durch jeden Taktimpuls umgeschaltet, so dass an den Ausgängen Q und Q̅, die in Fig. 2 angegebenen Signale auftreten. Am Ausgang des Univibrators 21 tritt bei jeder absteigenden Flanke des Taktsignals Clk ein kurzer Impuls auf. Diese Impulse sind in Fig. 2 mit 21 bezeichnet. Ueber die Tore 18 und 19 gelangen die Tastimpulse abwechslungsweise entweder an die beiden Tastschalter 9 und 11 oder beim nächsten Schritt an den Tastschalter 10. Es werden also je während eines Schrittes, etwa in der Mitte des Antriebsimpulses, jedenfalls aber im Bezug auf das Taktsignal immer mit derselben Phasenlage bzw. im gleichen Stadium die Spannungen U und U˝ bzw. U′ abgespeichert, indem bei jedem Tastimpuls der entsprechende Tastschalter kurzzeitig geschlossen wird. Solange der Motor stationär läuft, treten praktisch keine oder nur langsame Spannungsunterschiede auf, und die Spannungsabstufung an den Speicherkondensatoren 12, 13 und 14 wird stets praktisch dieselbe sein und die Abstufung wird in gleichbleibender Richtung liegen, d.h. am Kondensator 12 liegt die höchste, am Kondensator 13 eine mittlere und am Kondensator 14 die niedrigste Spannung. Die Ausgänge der Verstärker 15 und 16 sind im gleichen Zustand, was einen bestimmten Zustand am Ausgang des Tors 17 ergibt, welcher Zustand bezeichnend ist für den normalen Motorbetrieb. Beim Aussertrittfallen des Motors wird beispielsweise beim vierten Impuls in Fig. 2 eine wesentlich höhere Spannung abgegriffen als vorher und diese Spannung wird beispielsweise in die Kondensatoren 12 und 14 zugleich proportional eingespeichert. Am Kondensator 13 liegt dagegen die Spannung wie sie sich beim dritten Impuls ergeben hatte, also eine verhältnismässig wesentlich niedrigere Spannung. Es ist also jetzt durchaus möglich, dass die Spannung am Kondensator 14 diejenige am Kondensator 13 übersteigt, in welchem Falle das Signal am Ausgang des Verstärkers 16 ändert und somit auch das Signal am Ausgang des Tors 17 ändert und das Aussertrittfallen des Motors anzeigt. Wie empfindlich die Tast- und Vergleichsschaltung auf solche Spannungsunterschiede bzw. Stromunterschiede im Motor anspricht, hängt davon ab wie fein die Abstufung der Speicherspannungen an den Kondensatoren 12, 13 und 14 bzw. am Spannungsteiler 6, 7 und 8 gewählt ist. Eine gewisse Abstufung ist selbstverständlich erforderlich, um nicht bei geringfügigen, langsam erfolgenden Spannungsänderungen bzw. Stromänderungen ein nicht vorhandenes Aussertrittfallen anzuzeigen. In entsprechender Weise wie soeben beschrieben, würde die Schaltung bei jedem erheblichen Stromunterschied während eines Fortschaltimpulses gegenüber dem vorhergehenden Impuls ansprechen, beispielsweise wenn die Stromstärke beim fünften in Fig. 2 dargestellten Impuls wesentlich niedriger ist als beim vierten Impuls.

Beim Aussertrittfallen können geeignete Massnahmen getroffen werden. Bewegt der Motor ein Organ das gegen einen Anschlag läuft, kann das Aussertrittfallen anzeigen, dass die Anschlagposition erreicht ist, und in diesem Falle kann der Motor durch Ausschalten des Taktsignals Clk stillgesetzt werden. Es könnten allerdings auch andere, an sich übliche Konsequenzen gezogen, beispielsweise der Motorstrom erhöht werden, um ein erhöhtes Lastmoment zu überwinden.

Es ist oben erwähnt worden, dass die jeweilige Abtastung und Speicherung eines Momentanwertes des Motorstroms bzw. der Spannung U in einem geeignetem Zeitpunkt, etwa in der Mitte des Stromanstiegs, während jedes Antriebsimpulses stattfinden sollte. Eine entsprechende Einstellung bietet keine Schwierigkeiten, wenn der Motor stets mit praktisch gleicher Frequenz bzw. Drehzahl arbeitet, und wenn die Antriebsimpulse stets praktisch gleicher Länge aufweisen. Wenn jedoch die Antriebsfrequenz erheblich ändert oder eine Regelung der Impulsdauer stattfindet, um das Motordrehmoment möglichst unabhängig von Temperaturschwankungen und Schwankungen der Betriebsspannung, insbesondere beim Einsatz im Automobilbau, zu machen, muss vorzugsweise eine entsprechende Regelung des Tastzeitpunktes erfolgen. Eine solche Regelung folgt vorzugsweise durch Einwirkung auf einen entsprechenden Regeleingang des Univibrators 21, wobei ein Regelsignal in Abhängigkeit der Betriebsfrequenz oder der Betriebsspannung oder der Motortemperaturs hergeleitet werden kann. In Fig. 3 ist ein Teil einer derartigen Regelschaltung dargestellt. Der Motor 1 ist schematisch so dargestellt, wie wenn er aus einer Spannungsquelle mit der Spannung Um über einen Transistor 22 direkt mit Antriebsimpulsen gespeist würde. Der Transistor 22 wird gesteuert durch einen Univibrator 23, dem an einem Eingang das Taktsignal Clk zugeführt wird. Ein RC-Glied 24, 25, das mit der Betriebsspannung Um verbunden ist, ist mit einem Steuereingang 26 des Univibrators 23 verbunden und bewirkt dort während jedes Antriebsimpulses einen von der Betriebsspannung abhängigen Spannungsanstieg, der eine von der Betriebsspannung abhängige Regelung der Dauer der Antriebsimpulse in dem Sinne bewirkt, dass unabhängig von der Betriebsspannung ein praktisch konstantes Motordrehmoment resultiert. Die Impulsdauer kann dabei in recht weiten Grenzen variieren, was eine entsprechende Regelung des Zeitpunktes bzw. der Phase der Tastimpulse erforderlich macht. Zu diesem Zwecke ist mit dem Eingang 26 der ein Eingang eines Verstärkers bzw. einer Vergleichsschaltung 27 verbunden, dessen anderer Eingang mit einem Potentiometer 28 zur Einstellung der Schaltcharakteristik verbunden ist. Der Verstärker 27 wirkt auf einen Regeleingang des Univibrators 21 in dem Sinne, dass eine der Verkürzung der Antriebsimpulse bei steigender Betriebsspannung Um entsprechende Verschiebung der Taktimpulse am Ausgang des Univibrators 21 erfolgt. Wie erwähnt, kann stattdessen oder zusätzlich eine Regelung in Funktion der Betriebsfrequenz und/oder der Temperatur erfolgen. Die beiden Univibratoren 21 und 23 können mit dem IC 74 HC 123 realisiert werden.

Es ist schon erwähnt worden, dass die Tastschalter 9, 10 und 11 elektronische Schalter sind bzw., dass ein handelsüblicher Tastspeicher verwendet werden kann. In diesem Falle können selbstverständlich die momentanen Strom- bzw. Spannungswerte in digitale Speicher eingeführt werden, welche mit einer digitalen Vergleichsschaltung und einer entsprechenden Logik verbunden sind. Steht ein ohnehin vorhandener Mikroprozessor zur Verfügung, können ausserdem verschiedene Funktionen softwaremässig ausgeführt werden, insbesondere auch die oben beschriebene Regelung.

## Patentansprüche

1. Verfahren zum Erfassen des Aussertrittfallens eines Schritt- oder Synchronmotors, insbesondere Kleinmotors, dadurch gekennzeichnet, dass jeweils zu gleichen Zeitpunkten bezogen auf Antriebsimpulse der momentane Motorstrom erfasst und dessen Wert gespeichert wird, und dass die gespeicherten Werte verglichen und bei einen Grenzwert überschreitenden Abweichungen auf ein Aussertrittfallen geschlossen wird.

2. Verfahren nach Anspruch 1, dadurch gekennzeichnet, dass von jedem erfassten Momentan-Stromwert drei abgestufte Werte erzeugt werden, und dass abwechslungsweise der höchste und niedrigste zugleich und der mittlere allein gespeichert werden, dass fortgesetzt der höchste mit dem mittleren und der mittlere mit dem niedrigsten Wert verglichen wird, und dass beim Auftreten einer Abweichung beim Vergleich zweier Werte auf Aussertrittfallen geschlossen wird.

3. Verfahren nach Anspruch 1 oder 2, dadurch gekennzeichnet, dass der Momentanwert des Motorstromes in eine Spannung gewandelt und analog in Kondensatoren oder nach A/D-Wandlung in Digitalspeichern gespeichert wird.

4. Verfahren nach einem der Ansprüche 1-3, wobei die Dauer der dem Motor zugeführte Antriebsimpulse geregelt wird, dadurch gekennzeichnet, dass der Zeitpunkt der Erfassung des Momentan-Stromwertes in Abhängigkeit der Impulsdauer geregelt wird.

5. Verfahren nach Anspruch 4, dadurch gekennzeichnet, dass der Momentan-Stromwert jeweils etwa in der Mitte der Antriebsimpulse erfasst wird.

6. Schaltung zur Durchführung des Verfahrens nach Anspruch 1, gekennzeichnet durch Mittel (4) zur Messung des Motorstroms (I), einen Tastspeicher bzw. sample and hold device (5) zur Speicherung von Momentan-Messergebnissen, Mittel (18-21) zum Aktivieren des Tastspeichers (5) in einem bestimmten Zeitpunkt bezüglich des jeweiligen Antriebsimpulses und durch Vergleichsmittel (15,16) zum Vergleichen von Momentan-Messergebnissen.

7. Schaltung nach Anspruch 6, gekennzeichnet, durch Tastspeicher (9,12;10,13;11,14) für unterschiedliche, dem Momentan-Messergebnis proportionale Werte, welche nacheinander aktivierbar sind und deren Inhalte durch die Vergleichsmittel (15,16) dauernd verglichen werden.

8. Schaltung nach Anspruch 7, mit einem Taktsignaleingang (Clk) zur Steuerung der Frequenz der Antriebsimpulse, dadurch gekennzeichnet, dass der Takteingang (Clk) auch mit einem Univibrator (21) verbunden ist, wobei Ausgänge des Univibrators (21) und des Flip-Flop (20) mit einer Logik (18,19) verbunden sind, welche den Tastspeicher (5) aktiviert.

9. Schaltung nach einem der Ansprüche 6-8, gekennzeichnet durch eine erste Regelschaltung (24-26) zur Regelung der Dauer der Antriebsimpulse und eine damit verbundene zweite Regelschaltung (21,27) zur Regelung des Zeitpunktes der Aktivierung des Tastspeichers (5).

10. Schaltung nach Anspruch 9, dadurch gekennzeichnet, dass die erste Regelschaltung (24-26) ein RC-Glied (24,25) zur Erzeugung eines periodischen spannungsabhängigen und/oder temperaturabhängigen Verlaufs einer Regelspannung aufweist, und dass die zweite Regelschaltung (21,23) durch die Regelspannung angesteuert ist.

## Claims

1. Method of detection of the loss of synchronism of a stepping or synchron motor, more particularly of a small motor, characterized in that, as the case may be, one detects at the same time with respect to the motor pulses the momentary current of the motor, in that one stores its value and in that the stored values are compared and, in the case of a deviation surpassing a limit value, one concludes to a loss of synchronism

2. Method according to claim 1, characterized in that for each momentary value of the detected current, one produces three stages values and in that alternately, the highest and the lowest values are memorized at the time and the intermediate value is memorized alone, in that the highest value is continuously compared with the intermediate value and the intermediate with the lowest value, and in that at the time of apparition of a deviation during the control of two values, one concludes to a loss of synchronism.

3. Method according to claim 1 or 2, characterized in that the momentary value of the motor current is converted in a voltage and memorized in an analog way in condensers or, after an A/D conversion, in digital memories.

4. Method according to one of the claims 1-3, the duration of the motor pulse delivered to the motor being regulated, characterized in that the time of detection of the momentary value of the current is regulated as a function of the duration of the pulse.

5. Method according to claim 4, characterized in that the momentary value of the current is detected, as the case may be, about in the middle of the motor pulse

6. Cicuit for carrying out the method according to claim 1, characterized by means (4) for measuring the motor current (I), one sample and hold device (5) for storing the results of momentary measurements, means (18-21) for activating the sample and hold device (5) at a determined time with respect to the motor pulse and by comparing means (15-16) for comparing the results of the momentary measurements

7. Circuit according to claim 6, characterized by sample and hold devices (9,12;10,13;11,14) for various values proportional to the results of the momentary measurements, said values being activated one after the other, the contents of which being continuously compared by the comparing means

8. Circuit according to claim 7, with a clock input (Clk) for controlling the frequency of the driving pulses, characterized in that the clock input (Clk) is also connected to an univibrator (21), outputs of the univibrator (21) and of the flip-flop (20) being connected to a logic circuit (18,19) which activates the sample and hold device (5).j

9. Circuit selon l'une des revendications 6-8, characterized by a first control circuit (24-26) for regulating the duration of the driving pulse and a second control circuit (21,27) connected with said first circuit for regulating the instant of time of the activation of the sample and hold device (5).

10. Circuit according to claim 9. characterized in that the first control circuit (24-26) comprises a RC-element (24,25) for producing a periodical, voltage dependent and /or temperature dependent course of a control voltage, and in that the second control circuit (21,23) is controlled by the control voltage.

## Revendications

1. Procédé de détection de la perte de synchronisme d'un moteur pas à pas ou synchrone, plus particulièrement d'un petit moteur, caractérisé en ce que selon le cas, l'on détecte à de mêmes instants par rapport aux impulsions motrices le courant momentané du moteur, que l'on mémorise sa valeur et en ce que les valeurs mémorisées sont comparées et qu'en cas d'une déviation dépassant une valeur limite, on conclut à une perte de synchronisme.

2. Procédé selon la revendication 1, caractérisé en ce que pour chaque valeur momentanée du courant détecté, on produit trois valeurs étagées et en ce qu' alternativement la plus haute et la plus basse sont mémorisées en même temps et la moyenne est mémorisée seule, en ce que, de manière continue, la plus haute est comparée avec la moyenne et la moyenne avec la plus basse, et en ce que lors de l'apparition d'une déviation lors de contrôle de deux valeurs, on conclut à une perte de synchronisme.

3. Procédé selon la revendication 1 ou 2, caractérisé en ce que la valeur momentanée du courant du moteur est convertie en une tension et mémorisée de manière analogique dans des condensateurs ou, après une conversion A/D, dans des mémoires digitales.

4. Procédé selon l'une des revendications 1-3, la durée de l'impulsion motrice fournie au motor étant réglée, caractérisé en ce que l'instant de détection de la valeur momentanée du courant est réglée en fonction de la durée de l'impulsion.

5. Procédé selon la revendication 4, caractérisé en ce que la valeur momentanée du courant est détectée, selon le cas, environ au milieu de l'impulsion motrice

6. Circuit pour la mise en oeuvre du procédé selon la revendication 1, caractérisé. par des moyens (4) pour mesurer le courant du moteur (I), une mémoire à touche, resp. un dispositif sample and hold (5) pour mémoriser des résultats de mesure momentanés, des moyens (18-21) pour activer la mémoire à touches en un instant déterminé par rapport à l'impulsion motrice, et par des moyens de comparaison (15,16) pour comparer les résultats de mesure momentanés.

7. Circuit selon la revendication 6, caractérisé par des mémoires à touches (9,12;10,13;11,14) pour des valeurs différentes proportionnelles aux résultats de mesures momentanés, qui sont activables l'une après l'autre et dont les contenus sont comparés continuellement par les moyens de comparaison (15,16).

8. Circuit selon la revendication 7, avec une entrée pour un signal d'horloge
(Clk) pour la commande de la fréquence des impusions motrices. caractérisé en ce que l'entrée du signal (Clk) est aussi connectée à un univibrateur (21), des sorties de l'univibrateur (21 et du flip-flop (20) étant connectées avec une logique (18,19) qui active la mémoire à touches (5).

9. Circuit selon l' une des revendications (6-8), caractérisé par un premier circuit de réglage (24-26) pour le réglage de la durée de l'impulsion motrice et un second circuit de réglage (21-27) connecté au premier pour le réglage de l'instant de l'activation de la mémoire à touche

10. Circuit selon la revendication 9, caractérisé en ce que le premier circuit de réglage (24-26) comprend un élément RC (24-25) pour produire une allure périodique d'une tension de réglage dépendante de la tension et/ou dépendante de la température, et en ce que la seconde tension de réglage (21,23) est commandée par la tension de réglage
